# EUROPÄISCHE PATENTSCHRIFT

(11) **EP 0 493 676 B1**
(45) Veröffentlichungstag und Bekanntmachung des Hinweises auf die Patenterteilung: **08.02.1995**
(21) Anmeldenummer: 91120164.8
(22) Anmeldetag: 26.11.1991
(51) Int. Cl.: H01J 9/02, H01J 1/30, H01L 21/20

(54) **Verfahren zur Herstellung einer elektrisch leitenden Spitze aus einem dotierten Halbleitermaterial**
Process for manufacturing an electric conducting point from a doped semiconducting material
Procédé pour la fabrication d'une pointe conductrice d'électricité à partir d'un matériau semi-conducteur dopé

(30) Priorität: 21.12.1990 DE 4041276
(43) Veröffentlichungstag der Anmeldung: 08.07.1992
(73) Patentinhaber: SIEMENS AKTIENGESELLSCHAFT, 80333 München (DE)
(72) Erfinder: Stengel, Reinhard, Dr., W-8901 Stadtbergen (DE); Meul, Hans W., Dr., W-8206 Bruckmühl (DE); Hönlein, Wolfgang, Dr., W-8025 Unterhaching (DE)

(56) Entgegenhaltungen:
- EP-A- 0 150 885
- WO-A-88/06345
- WO-A-89/09479
- US-A- 4 513 308
- US-A- 4 883 215
- IEEE TRANSACTIONS ON ELECTRON DEVICES. Bd. 36, Nr. 11, November 1989, NEW YORKUS Seiten 2703 - 2708; R. A. LEE ET AL: 'Semiconductor fabrication technologyapplied to micrometer valves'

## Beschreibung

### Verfahren zur Herstellung einer elektrisch leitenden Spitze aus einem dotierten Halbleitermaterial

Die kalte Feldemission aus elektrisch leitenden Spitzen mit Spitzenradien im nm-Bereich wird zunehmend für elektronische Bauelemente und Anzeigen benutzt.

Aus W. G. Ornis et al., IEEE Trans. ED Vol. 36 No. 11 1989, pp. 2651-2657 ist z. B. eine Kaltkathoden-Triode bekannt. In dem bekannten Bauelement ist auf einer Siliziumscheibe eine Siliziumspitze angeordnet, die eine Kathode bildet. Von der Kathode isoliert ist gegenüber der Spitze eine flächige Anode angeordnet. Auf der Höhe der Kathode ist ringförmig von der Kathode und der Anode isoliert eine Gateelektrode angeordnet. Legt man zwischen die Kathode (negativ) und die Anode (positiv) eine Spannung der Größe V_{AK} an, so emittiert die Kathode Elektronen bei Feldstärken in der Größenordnung 10⁷ V/cm. Diese Feldstärke ist proportional V_{AK}/r, wobei r der Spitzenradius der Kathode ist. Durch Anlegen einer Spannung an die Gateelektrode kann dieser Elektronenstrom gesteuert werden.

Der Gleichrichtereffekt dieses Bauelementes entsteht durch die unterschiedliche Geometrie von Kathode (Spitze) und Anode (Platte). Daher wird die Emissionsfeldstärke an der Kathode bei wesentlich kleinerer Spannung V_{AK} erreicht als an der flachen Anode.

WO-A-8 909 479 offenbart ein Verfahren zur Herstellung einer leitenden Spitze, bei dem eine Maske mit drei Schichten erzergt wird, wobei auf das Substrat eine erste Schicht und eine dritte Schicht aus einem Material aufgebracht werden, auf der ein halbleiter material bei selektiver Epitaxie nicht auf wächst. Eine zweite leitende Schicht aus Metal liegt dazwischen. Das Substrat wird freigelegt und die Schicht geätzt, und eine Spitze durch Epitaxie auf das Substrat erzeugt.

Aus R. A. Lee et. al., IEEE Trans. ED Vol. 36 No. 11, 1989, pp. 2703-2708 und R. N. Thomas et al., Solid St. Electr. 1974, Vol. 17, pp. 155-163 sind Verfahren zur Herstellung von Emitterspitzen bekannt. Dabei werden mit Hilfe eines Photolithographieschrittes z. B. kreisförmige Gebiete auf einer oxidierten Siliziumscheibe so freigeätzt, daß in der Mitte des kreisförmigen Gebietes ein Oxidfleck verbleibt. Danach wird mit Hilfe anisotroper oder isotroper Ätzung der in der Mitte des Kreises verbliebene Oxidfleck unterätzt. Dabei entsteht aufgrund der kristallinen Struktur des Siliziums eine Spitze mit entsprechenden Flanken, z. B. <111> auf <100> . Nach Beendigung der Unterätzung lösen sich die Oxidflecken ab und die Spitze wird freigelegt.

In diesem Verfahren ist bei der gleichzeitigen Herstellung mehrerer Spitzen die Spitzengeometrie und damit die Emissionsfähigkeit durch lokale Schwankungen der Ätzrate beeinflußt.

Der Erfindung liegt das Problem zugrunde, ein Verfahren zur Herstellung von elektrisch leitenden Spitzen anzugeben, das eine leicht kontrollierbare Einstellung der Spitzenradien im nm-Bereich erlaubt.

Das Problem wird erfindungsgemäß gelöst durch ein Verfahren nach Anspruch 1.

Die Erfindung macht sich die Tatsache zu nutze, daß es bei der selektiven Epitaxie, insbesondere von Silizium, zu einer Facettenbildung an maskierenden Strukturen kommt. Eine punktförmige Spitze entsteht dabei, wenn der Durchmesser der Öffnung, in der die Spitze durch selektive Epitaxie aufgewachsen wird, kleiner ist als 2 x die Höhe der Spitze.

Gemäß der Erfindung wird die Maskenschicht als Dreifachschicht gebildet. Dabei wird auf das Substrat eine erste Schicht aus einem Material aufgebracht, auf das das Halbleitermaterial bei der selektiven Epitaxie nicht aufwächst. Auf die erste Schicht wird eine zweite Schicht aus dem dotierten Halbleitermaterial aufgebracht. Auf die zweite Schicht wird eine dritte Schicht aus einem Material aufgebracht, auf das das Halbleitermaterial bei der selektiven Epitaxie nicht aufwächst. Bei der selektiven Epitaxie zur Bildung der leitenden Spitze wächst in diesem Fall das Halbleitermaterial auch an den Flanken der zweiten Schicht auf.

Die Öffnung in der Maskenschicht wird insbesondere durch einen anisotropen Ätzprozeß erzeugt. Es liegt im Rahmen der Erfindung, dabei die zweite Schicht in einem isotropen Ätzprozeß um einen definierten Betrag unter die dritte Schicht zu unterätzen. Über diese Unterätzung wird der Abstand zwischen dem an den Flanken der zweiten Schicht aufgewachsenen Halbleitermaterial und der leitenden Spitze eingestellt.

Weitere Ausgestaltungen der Erfindung gehen aus den übrigen Ansprüchen hervor.

Im weiteren wird die Erfindung anhand eines Ausführungsbeispiels und der Figuren näher erläutert.
- Fig. 1 bis Fig. 5: zeigt Verfahrensschritte zur Herstellung einer leitenden Spitze auf einem Halbleitersubstrat.
- Fig. 6 und Fig. 7: zeigt die Herstellung einer Kaltkathoden-Vakuumröhre unter Verwendung einer erfindungsgemäß hergestellten leitenden Spitze als Kathode.
- Fig. 8: zeigt eine kompakte Ausführungsform einer Kaltkathode-Vakuumröhre.

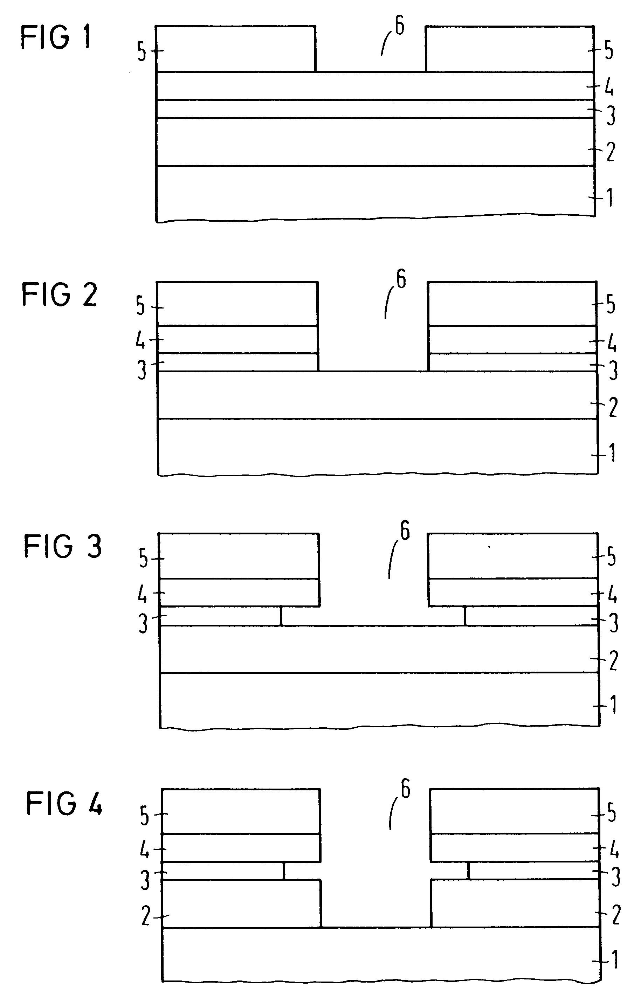

Auf ein Substrat 1 aus <100> Silizium, das hochdotiert und n-leitend, z. B. 0,02 Ωcm Sb dotiert ist, wird ganzflächig eine erste Isolatorschicht 2 aufgebracht (s. Fig. 1). Die erste Isolatorschicht 2 ist z. B. 0,1 bis 0,5 »m dick und besteht z. B. aus thermischem oder CVD-Siliziumdioxid. Auf die erste Isolatorschicht 2 wird eine dotierte, elektrisch leitende Schicht 3 aufgebracht. Die elektrisch leitende Schicht 3 besteht z. B. aus n⁺-dotiertem amorphem Silizium und ist z. B. 0,1 »m dick.

Auf die elektrisch leitende Schicht 3 wird eine zweite Isolatorschicht 4 aufgebracht. Die zweite Isolatorschicht 4 ist z. B. 0,1 bis 0,2 »m dick. Die zweite Isolatorschicht 4 wird z. B. als Doppelschicht bestehend aus einer etwa 50 nm dicken thermischen Siliziumoxidschicht und einer ca. 0,1 bis 0,2 »m dicken LPCVD-Borphosphorsilikatglasschicht gebildet. Zur Erzeugung einer glatten Oberfläche wird die Borphosphorsilikatglasschicht bei 900 °C feucht getempert.

Auf die zweite Isolatorschicht 4 wird eine Photolackschicht 5 aufgeschleudert und nach einem Photolithographieschritt strukturiert. Unter Verwendung der strukturierten Photolackschicht 5 als Ätzmaske wird mit geeigneten anisotropen Ätzverfahren eine Öffnung 6 in die zweite Isolatorschicht 4 und in die elektrisch leitende Schicht 3 geätzt (s. Fig. 2). Die Öffnung 6 weist eine Weite w von z. B. 0,6 »m auf.

Als nächstes wird die elektrisch leitende Schicht 3 lateral naßchemisch unter die zweite Isolatorschicht 4 zurückgeätzt (s. Fig. 3). Ein solches naßchemisches, isotropes Ätzen ist über die Ätzdauer gut kontrollierbar. Die Unterätzung der elektrisch leitenden Schicht 3 unter die zweite Isolatorschicht 4 beträgt z. B. x = 0,8 »m.

Selbstjustiert zur elektrisch leitenden Schicht 3 wird die erste Isolatorschicht 2 anschließend unter Verwendung der ursprünglichen Photolackschicht 5 als Ätzmaske bis zur Freilegung der Oberfläche des Substrats 1 anisotrop geätzt (s. Fig. 4). Dadurch wird die Öffnung 6 bis zur Oberfläche des Substrats 1 vergrößert.

Im nächsten Schritt wird die Photolackschicht 5 entfernt. Es folgen bekannte Reinigungsschritte zur Vorbereitung der freiliegenden Oberfläche des Substrats 1 für die anschließende selektive Siliziumepitaxie.

Anschließend wird die selektive Siliziumepitaxie durchgeführt. Bei der Abscheidung werden z. B. die folgenden Prozeßparameter eingehalten: Als Prozeßgase werden HCl mit einer Durchflußrate von 140 sccm, SiCl₂H₂ mit einer Durchflußrate von 200 sccm, (standard Kubik-Centimeter pro Minute) PH₃ mit einer Durchflußrate von 300 sccm und H₂ mit einer Durchflußrate von 60 slm (standard Liter pro Minute) verwendet. Der Gesamtdruck beträgt 13,3 hPa. Die Temperatur an dem Substrat 1 wird auf 850 °C gehalten.

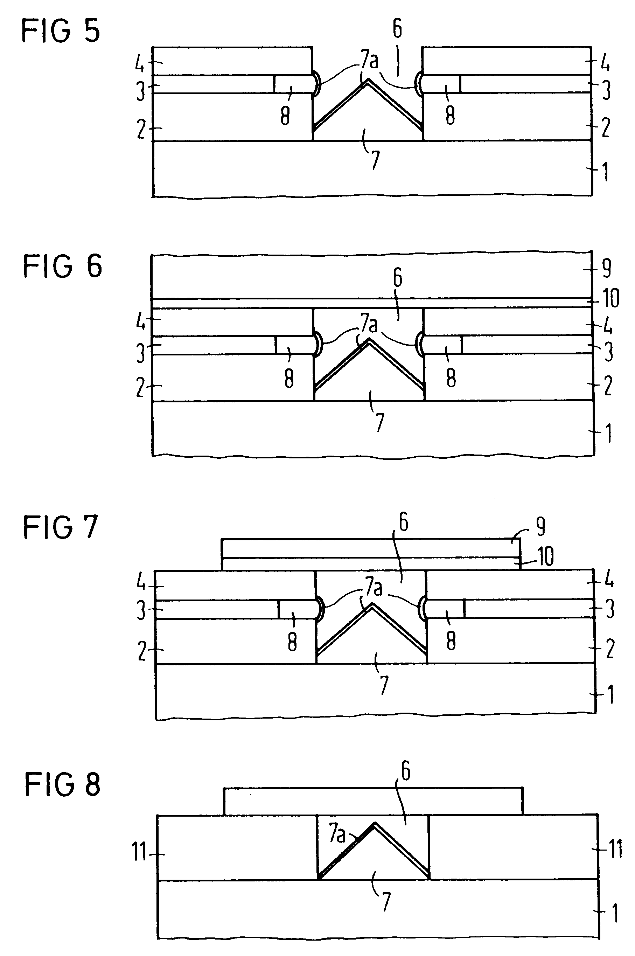

Mit diesen Prozeßparametern wächst auf der in der Öffnung 6 freiliegenden Oberfläche des Substrats 1 eine in-situ-dotierte, n⁺-leitende pyramidenförmige Spitze 7 auf (s. Fig. 5). Damit eine punktförmige Spitze entsteht, ist es entscheidend, daß die Höhe der Spitze 7 größer ist als die halbe Weite w/2 der Öffnung 6.

Bei der selektiven Siliziumepitaxie wächst auch an den freiliegenden Kanten der elektrisch leitenden Schicht 3 aus Silizium eine polykristalline Siliziumstruktur 8 an (s. Fig. 5). Die Dicke der ersten Isolatorschicht 2 wird so an die Weite w der Öffnung 6 angepaßt, daß die Spitze 7 eine punktförmige Spitze bildet, die in etwa auf der Höhe der polykristallinen Siliziumstruktur 8 liegt. Der Abstand zwischen der polykristallinen Siliziumstruktur 8 und der Spitze 7 a ist dann kleiner als die halbe Weite w/2 der Öffnung 6 + x, wobei x die Ausdehnung der Unterätzung der elektrisch leitenden Schicht 3 unter die zweite Isolatorschicht 4 ist. Der Abstand a ist also durch die gezielte Unterätzung x beliebig einstellbar. Der Abstand a ist unabhängig vom Auflösungsvermögen oder der Justiertoleranz einer Photolithographie. Durch Verwendung einer Sub-»m-Lithographie zur Strukturierung der Öffnung 6 mit z. B. w kleiner 0,3 »m ist die Spitze 7 in einer Geometrie herstellbar wie sie für Kaltkathoden mit Einsatzspannungen unter 10 Volt erforderlich sind.

Die Emissionsfähigkeit der Spitze 7 bei einer Anwendung z. B. als Kaltkathode kann durch eine selektiv auf freiliegende Siliziumoberflächen aufgebrachte Metallschicht 7a verbessert werden (s. Fig. 5). Dies geschieht z. B. mit Hilfe einer selektiven Metall-CVD-Abscheidung oder mit Hilfe eines selektiven Silizierverfahren. Die Metallschicht 7a besteht z. B. aus TiSi₂.

Zur Fertigstellung einer Kaltkathoden-Vakuumröhre wird die Öffnung 6 verschlossen (s. Fig. 6). Dies erfolgt z. B. dadurch, daß auf die zweite Isolatorschicht 4 in einem Waferbonding-Verfahren, wie es z. B. aus US-PS 4 883 215 bekannt ist, ein weiteres Substrat 9 aufgebracht wird. Das weitere Substrat 9 weist mindestens an seiner der zweiten Isolatorschicht 4 zugewandten Oberfläche eine glatte SiO₂-Schicht 10 auf. Vorbedingung zur Anwendung des Waferbonding-Verfahrens ist, daß die zu verbindenden Oberflächen beide sehr plan sind und aus SiO₂ bestehen. Für das Waferbonding-Verfahren geeignete Oberflächen bestehen z. B. aus thermischen Oxiden oder aus abgeschiedenen Oxiden mit einem hohen Anteil an Weichmachern, wie es z. B. in Borphosphorsilikatglas der Fall ist. Die Oberfläche der zweiten Isolatorschicht 4, wie sie in diesem Ausführungsbeispiel hergestellt wurde, erfüllt die Anforderungen zum Waferbonden. Das weitere Substrat 9 besteht z. B. aus n⁺-dotiertem oder p⁺-dotiertem Silizium oder aus einem lichtdurchlässigen, leitenden Material für Displays.

Es ist besonders vorteilhaft, das Waferbonden in einer O₂-Atmosphäre durchzuführen. Bei dem Bonden ist ein Temperschritt notwendig. Bei diesem Temperschritt werden in reiner O₂-Atmosphäre an die Öffnung 6 angrenzende Siliziumflächen oxidiert. Bei dieser Oxidation bildet sich ein Vakuum mit einem Restgasdruck, der dem Dampfdruck von SiO₂ entspricht.

Durch Dünnschleifen des weiteren Substrates 9 und Strukturierung des weiteren Substrates 9 mittels einer unkritischen Phototechnik wird die Kaltkathoden-Vakuumröhre fertiggestellt (s. Fig. 7).

In der fertigen Kaltkathoden-Vakuumröhre bildet die Spitze 7 die Kathode, die elektrisch leitende Schicht 3 mit den polykristallinen Siliziumstrukturen 8 die Steuerelektrode, das weitere Substrat 9 die Anode und die Öffnung 6 den Röhreninnenraum.

Durch Anwendung des erfindungsgemäßen Verfahrens ist der Abstand zwischen der Spitze der Kathode und der Anode, der für die Elektronenemission einen wichtigen Parameter darstellt, nur über die Höhe der Spitze 7 festgelegt. Diese Höhe ist bei Temperaturen um 850 °C über Oberflächenreaktionen sehr genau einstellbar.

Eine vereinfachte Ausführungsform der Erfindung sieht vor, anstelle der ersten Isolationsschicht 2, der elektrisch leitenden Schicht 3 und der zweiten Isolationsschicht 4 nur eine einzige Isolationsschicht 11 vorzusehen (s. Fig. 8). Die einzige Isolationsschicht 11 besteht z. B. aus einem thermischen SiO₂, das in einer Dicke H von z. B. 1 »m aufgebracht wird, die größer ist als die halbe Weite w/2 von z. B. 0,3 »m der Öffnung 6. In Fig. 8 wurden für gleiche Teile die gleichen Bezugszeichen wie in Fig. 1 bis 7 verwendet. Diese Ausführungsform erlaubt die Herstellung von Kaltkathoden-Emitterfeldern höchster Packungsdichte.

Das erfindungsgemäße Herstellverfahren, das hier anhand eines n-dotierten Siliziumsubstrats beschrieben wurde, ist ebenso durchführbar auf der Basis eines p-dotierten Siliziumsubstrats.

## Patentansprüche

1. Verfahren zur Herstellung einer elektrisch leitenden Spitze aus einem dotierten Halbleitermaterial mit folgenden Schritten:
a) auf einem Substrat (1) aus dem Halbleitermaterial wird eine Maskenschicht (2, 3, 4, 11) erzeugt, die auf dem Substrat (1) eine erste Schicht (2) aus einem Material, auf dem das Halbleitermaterial bei einer selektiven Epitaxie nicht aufwächst, darauf eine zweite Schicht (3) aus dem dotierten Halbleitermaterial und darauf eine dritte Schicht (4) aus einem Material, auf dem das Halbleitermaterial bei einer selektiven Epitaxie nicht aufwächst, umfaßt,
b) in der Maskenschicht (2, 3, 4, 11) wird eine Öffnung (6) erzeugt, in der die Oberfläche des Substrats (1) freiliegt,
c) in einem isotropen Ätzprozeß wird die zweite Schicht (3) um einen definierten Betrag unter die dritte Schicht (4) unterätzt,
d) auf der freiliegenden Oberfläche des Substrats (1) wird die elektrisch leitende Spitze (7) durch eine selektive Epitaxie erzeugt, bei der das Schichtwachstum in der Richtung parallel zur Oberfläche des Substrats (1) geringer ist als in Richtung senkrecht zur Oberfläche des Substrats (1) und bei der auch an den Flanken der zweiten Schicht (4) das Halbleitermaterial aufwächst.

2. Verfahren nach Anspruch 1,
bei dem die selektive Epitaxie durch Abscheidung aus der Gasphase erfolgt und das Halbleitermaterial dabei in-situ-dotiert wird.

3. Verfahren nach Anspruch 2,
bei dem als Halbleitermaterial Silizium verwendet wird.

4. Verfahren nach Anspruch 3,
bei dem die selektive Epitaxie unter Verwendung H₂, HCl und SiCl₂H₂ als Prozeßgase durchgeführt wird.

5. Verfahren nach Anspruch 4,
bei dem die Durchflußrate für H₂ zwischen 10 slm und 200 slm, die Durchflußrate für HCl zwischen 0 slm und 1 slm, die Durchflußrate für SiCl₂H₂ zwischen 30 sccm und 1000 sccm, die Temperatur des Substrats zwischen 800°C und 1000°C und der Gesamtdruck der Prozeßgase zwischen 133 Pa und 5333 Pa liegt.

6. Verfahren nach einem der Ansprüche 1 bis 5,
bei dem die Dicke der Maskenschicht (2, 3, 4, 11) größer ist als die Höhe der leitenden Spitze (7).

7. Verfahren nach einem der Ansprüche 1 bis 6 mit folgenden Schritten:
a) die Öffnung (6) in der Maskenschicht (2, 3, 4) wird durch anisotropes Ätzen erzeugt,
b) die leitende Spitze (7) wird in einer solchen Höhe aufgewachsen, daß der Abstand zwischen der dem Substrat (1) abgewandten Seite der Spitze (7) und der Oberfläche des Substrats (1) und der Abstand zwischen der Mitte der zweiten Schicht (3) und der Oberfläche des Substrats (1) im wesentlichen gleich sind.

8. Verfahren nach Anspruch 7,
bei dem auf die leitende Spitze (7) selektiv eine Metallschicht (7a) aufgebracht wird.

9. Verfahren nach einem der Ansprüche 1 bis 8,
bei dem mindestens an der Oberfläche der Maskenschicht (2, 3, 4) eine SiO₂-Schicht (4) mit glatter Oberfläche erzeugt wird, auf die mittels Waferbonden ein weiteres Substrat (9) aufgebracht wird, das mindestens an der der SiO₂-Schicht zugewandten Seite mit einer glatten SiO₂-Oberfläche (10) versehen ist.

10. Verfahren nach Anspruch 9,
bei dem das Waferbonden in reiner O₂-Atmosphäre durchgeführt wird.

## Claims

1. Method for producing an electrically conductive tip from a doped semiconductor material, having the following steps:
a) a mask layer (2, 3, 4, 11) is produced on a substrate (1) composed of the semiconductor material, which mask layer (2, 3, 4, 11) on the substrate (1) comprises a first layer (2) composed of a material on which the semiconductor material does not grow during selective epitaxy, a second layer (3) thereon composed of the doped semiconductor material, and a third layer (4) thereon composed of a material on which the semiconductor material does not grow during selective epitaxy,
b) an opening (6) is produced in the mask layer (2, 3, 4, 11), in which opening (6) the surface of the substrate (1) is exposed,
c) the second layer (3) is etched back by a defined amount under the third layer (4) in an isotropic etching process,
d) the electrically conductive tip (7) is produced on the exposed surface of the substrate (1) by selective epitaxy, during which epitaxy the layer growth in the direction parallel to the surface of the substrate (1) is less than in the direction at right angles to the surface of the substrate (1) and during which the semiconductor material also grows on the edges of the second layer (4).

2. Method according to Claim 1, during which the selective epitaxy is carried out by deposition from the gaseous state and the semiconductor material is in this case doped in-situ.

3. Method according to Claim 2, in which silicon is used as the semiconductor material.

4. Method according to Claim 3, in which the selective epitaxy is carried out using H₂, HCl and SiCl₂H₂ as process gases.

5. Method according to Claim 4, during which the flow rate for H₂ is between 10 slm and 200 slm, the flow rate for HCl is between 0 slm and 1 slm, the flow rate for SiCl₂H₂ is between 30 sccm and 1,000 sccm, the temperature of the substrate is between 800°C and 1,000°C, and the total pressure of the process gases is between 133 Pa and 5,333 Pa.

6. Method according to one of Claims 1 to 5, in the case of which the thickness of the mask layer (2, 3, 4, 11) is greater than the height of the conductive tip (7).

7. Method according to one of Claims 1 to 6, having the following steps:
a) the opening (6) in the mask layer (2, 3, 4) is produced by anisotropic etching,
b) the conductive tip (7) is grown to such a height that the distance between that side of the tip (7) which faces away from the substrate (1) and the surface of the substrate (1), and the distance between the centre of the second layer (3) on the surface of the substrate (1), are essentially equal.

8. Method according to Claim 7, in which a metal layer (7a) is selectively applied onto the conductive tip (7).

9. Method according to one of Claims 1 to 8, in which a SiO₂ layer (4) with a smooth surface is produced at least on the surface of the mask layer (2, 3, 4), onto which SiO₂ layer (4) a further substrate (9) is fitted by means of wafer bonding, which further substrate (9) is provided with a smooth SiO₂ surface (10) at least on the side facing the SiO₂ layer.

10. Method according to Claim 9, in which the wafer bonding is carried out in a pure O₂ atmosphere.

## Revendications

1. Procédé pour fabriquer une pointe électriquement conductrice réalisée en un matériau semiconducteur dopé, comprenant les étapes opératoires suivantes :
a) sur un substrat (1) formé d'un matériau semiconducteur, on forme une couche de masque (2,3,4,11), qui comprend, sur le substrat (1), une première couche (2) formée d'un matériau sur lequel il ne se produit aucune croissance du matériau semiconducteur lors d'une épitaxie sélective, et sur cette couche une seconde couche (3) formée d'un matériau semiconducteur dopé et, sur cette couche, une troisième couche (4) formée d'un matériau sur lequel il ne se produit aucune croissance du matériau semiconducteur lors d'une épitaxie sélective,
b) dans la couche de masque (2,3,4,11), on produit une ouverture (6), dans laquelle la surface du substrat (11) est à nu,
c) lors d'un processus de corrosion isotrope, on exécute une corrosion sous-jacente de la seconde couche (3), sur une hauteur définie au-dessous de la troisième couche (4),
d) sur la surface à nu du substrat (1), on forme la pointe électriquement conductrice (7) au moyen d'une épitaxie sélective, lors de laquelle la croissance de la couche est plus faible dans la direction parallèle à la surface du substrat (1) que dans une direction perpendiculaire à la surface du substrat (1) et lors de laquelle il se produit une croissance du matériau semiconducteur également sur les flancs de la seconde couche (4).

2. Procédé suivant la revendication 1, selon lequel l'épitaxie sélective s'effectue au moyen d'un dépôt à partir de la phase gazeuse et le matériau semiconducteur est dopé in situ.

3. Procédé suivant la revendication 2, caractérisé par le fait qu'on utilise du silicium comme matériau semiconducteur.

4. Procédé suivant la revendication 3, selon lequel on exécute l'épitaxie sélective en utilisant du H₂, du HCl et du SiCl₂H₂ en tant que gaz de traitement.

5. Procédé suivant la revendication 4, selon lequel le débit de passage pour H₂ est compris entre 10 slm et 200 slm, le débit de passage pour le HCl est compris entre 0 slm et 1 slm, le débit de passage pour le SiCl₂H₂ est compris entre 30 cm³ et 1000 cm³ dans les conditions standards, la température du substrat est comprise entre 800°C et 1000°C et la pression totale des gaz de traitement est comprise entre 133 Pa et 5333 Pa.

6. Procédé suivant l'une des revendications 1 à 5, selon lequel l'épaisseur de la couche de masque (2,3,4,11) est supérieure à la hauteur de la pointe conductrice (7).

7. Procédé suivant l'une des revendications 1 à 6, comprenant les étapes opératoires suivantes :
a) on forme l'ouverture (6) dans la couche de masque (2,3) au moyen d'une corrosion anisotrope,
b) on fait croître la pointe conductrice (7) sur une hauteur telle que la distance entre le côté de la pointe (7), tourné à l'opposé du substrat (1), et la surface du substrat (1) et la distance entre le centre de la seconde couche (3) et la surface du substrat (1) sont sensiblement égales.

8. Procédé suivant la revendication 7, selon lequel on dépose de façon sélective une couche métallique (7a) sur la pointe conductrice (7).

9. Procédé suivant l'une des revendications 1 à 8, selon lequel on forme, au moins sur la surface de la couche de masque (2,3,4), une couche (4) de SiO₂ possédant une surface lisse et sur laquelle on dépose, au moyen d'une liaison Waferbonden, un autre substrat (9), qui possède, au moins sur sa face tournée vers la couche de SiO₂, une surface lisse (10) de SiO₂.

10. Procédé suivant la revendication 9, selon lequel on exécute la liaison Waferbonden dans une atmosphère de O₂ pur.
